Europäisches Patentamt

**European Patent Office**

Office européen des brevets

(11) Numéro de publication: **0 295 160 B1**

(12) **FASCICULE DE BREVET EUROPEEN**

(45) Date de publication de fascicule du brevet: **03.02.93**  (51) Int. Cl.5: **G01R 23/02**, G01R 25/00

(21) Numéro de dépôt: **88401156.0**

(22) Date de dépôt: **11.05.88**

(54) **Procédé d'évaluation numérique de la fréquence et de la phase de signaux et dispositifs de mise en oeuvre d'un tel procédé.**

(30) Priorité: **21.05.87 FR 8707130**

(43) Date de publication de la demande:
**14.12.88 Bulletin 88/50**

(45) Mention de la délivrance du brevet:
**03.02.93 Bulletin 93/05**

(84) Etats contractants désignés:
**AT BE CH DE ES FR GB GR IT LI LU NL SE**

(56) Documents cités:
**EP-A- 0 107 884**
**EP-A- 0 166 839**
**EP-A- 0 186 521**
**US-A- 4 644 268**
**US-A- 4 661 769**

**SIGNAL PROCESSING, vol. 11, no. 2, septembre 1986, pages 169-177, Amsterdam, NL; D.R.A. McMAHON et al.: "An efficient method for the estimation of the frequency of a single tone in noise from the phases of discrete fourier transforms"**

(73) Titulaire: **ALCATEL ESPACE**
**11, avenue Dubonnet**
**F-92407 Courbevoie Cédex(FR)**

(84) Etats contractants désignés:
**FR GB IT**

(73) Titulaire: **Alcatel N.V.**
**Strawinskylaan 537**
**NL-1077 XX Amsterdam(NL)**

(84) Etats contractants désignés:
**BE CH DE ES GR LI LU NL SE AT**

(72) Inventeur: **Fontanes, Sylvain**
**34, avenue Guy de Maupassant**
**F-78400 Chatou(FR)**
Inventeur: **Birot, Patrice**
**42, Terrasse de l'Iris La Defense 2**
**F-92400 Courbevoie(FR)**
Inventeur: **Marguinaud, André**
**20, rue Léon Bertault**
**F-91120 Palaiseau(FR)**
Inventeur: **Ouignon, Thierry**
**7, rue de l'Ouest**
**F-92000 Nanterre(FR)**
Inventeur: **Romann, Brigitte**
**21, Allée de la Belle Feuille**
**F-92100 Boulogne Billancourt(FR)**

Rank Xerox (UK) Business Services

(74) Mandataire: **Pothet, Jean Rémy Emile Ludovic et al**
**c/o SOSPI 14-16 rue de la Baume**
**F-75008 Paris(FR)**

**EP 0 295 160 B1**

## Description

L'invention concerne un procédé d'évaluation numérique de la fréquence et de la phase de signaux et des dispositifs de mise en oeuvre d'un tel procédé.

Elle permet de restituer comme dans un fréquencemètre ou un phasemètre traditionnel, respectivement la fréquence ou la phase du signal à évaluer, assorti à la précision de mesure de ces paramètres et d'éléments d'appréciation de la qualité du signal (rapport signal/bruit, facteur de forme par exemple).

Le document US-A-4 661 769 décrit un procédé basé sur une solution optimale non réalisable que l'on simplifie pour en permettre la réalisation. Selon ce procédé on effectue un calcul récursif tenant compte des estimations précédentes.

Les procédés d'analyse des signaux couramment utilisés dans la mesure de fréquence et de phase sont basés en général :

- soit sur des procédés analogiques de traitement et de filtrage permettant la mise en oeuvre d'une intégration ou d'un comptage des passages par zéro, la durée de l'intégration ou de filtrage étant fonction de la précision recherchée ;
- soit sur des procédés permettant d'asservir un oscillateur, par exemple à l'aide d'une boucle "phase lock", isolant ainsi le signal à mesurer sur lequel on peut alors effectuer les mesures ;
- soit directement sur le signal issu de l'oscillateur asservi, ou encore sur les signaux de commande de ce dernier.

L'utilisation de ces procédés présente l'inconvénient de ne pouvoir garder en mémoire que les résultats d'un traitement préalable. De ce fait, toute valeur estimée d'un paramètre est utilisée pour traiter une partie de signal postérieure à celle qui a servi à l'estimation intiale, ce qui à des conséquences néfastes :

- sur les performances : car, selon ce principe on ne s'adapte pas au mieux à la variabilité des paramètres et de ce fait on est plus sensible aux signaux perturbateurs (bruit - raie parasite) superposés aux signaux à mesurer ;
- sur la complexité car en utilisant les principes décrits ci-dessus, il est très difficile de s'adapter au mieux à chacune des étapes que l'on doit mettre en oeuvre pour aboutir au but recherché. En particulier, les étapes d'acquisition et de poursuite nécessitent soit des dispositifs différents, soit des caractéristiques de circuits analogiques adaptés à chacune des étapes et il est très difficile, sans compliquer les dispositifs mis en oeuvre, d'exploiter et d'adapter au mieux le dispositif de mesure à chacune des étapes.

Par ailleurs, il n'est pas possible d'exploiter, au cours d'estimations successives d'un même paramètre, le même signal. Les résultats d'estimations successives sont ainsi effectués sur des périodes de signaux prises successivement dans le temps ce qui oblique à faire des hypothèses de manière à garantir la validité et la reproductibilité des résultats.

La présente invention a pour objet de pallier ces inconvénients.

Elle propose à cet effet un procédé d'évaluation numérique de la fréquence et de la phase de signaux sous forme d'échantillons numérisés comprenant une phase de traitement des nombres correspondant aux échantillons du signal à analyser pour les mettre sous forme d'un signal analytique dont la partie réelle coïncide avec ledit signal à analyser ; caractérisé en ce que ledit procédé comprend en parallèle :

- Une phase d'estimation des paramètres à analyser effectuée de manière globale à partir d'estimateurs optimaux au sens du maximum de vraisemblance et de l'erreur quadratique moyenne et de critères de choix travaillant de manière non récursive sur la phase du signal sans qu'aucun opérateur de type transformée de Fourier ni test d'hypothèses ne soit utilisé séparément ou simultanément ;
- Une phase d'estimation des écarts entre le signal réel ainsi apprécié et le signal obtenu en partant des paramètres estimés permettant de délivrer sous forme numérique des données relatives à la qualité du signal analysé ainsi qu'à la sûreté de valeurs estimées.

Ces différentes étapes sont avantageusement réalisées au moyen d'un ensemble matériel composé d'un numériseur et d'un organe de calcul, permettant d'accepter toute une variété de signaux et de restituer les paramètres souhaités.

Avantageusement dans la phase d'estimation des paramètres à analyser la phase du signal analytique est remplacée par sa phase développée associée.

Avec le procédé de l'invention on peut utiliser des estimateurs non biaisés et à variance minimale, ce qui permet d'optimiser la durée de signal traité.

De plus l'estimation du degré de conformité du signal analysé permet d'éliminer les brouilleurs en particulier dans le cas où le signal à analyser est fugitif. Cela permet d'envisager l'extraction des paramètres caractéristiques d'un signal bref, connaissant son instant d'apparition probable ou la détermination de l'instant d'apparition d'un signal de caractéristiques connues. Par exemple, considérant un message émis périodiquement ou de manière aléatoire, on peut en utilisant le procédé :

. déterminer de manière précise les instants de début du message afin d'en extraire ensuite les caractéristiques ;

. ou bien, si le message dont les caractéristiques sont parfaitement connues, arrive de manière aléatoire déterminer l'instant de début du message.

Plus précisément dans le procédé de l'invention des échantillons de départ sont stockés en mémoire d'ou ils sont extrait autant de fois que nécessaire pour le calcul effectué en partant d'un paramètre de qualité pour déduire, avec une précision donnée, le rapport signal/bruit du signal analysé, la durée de signal pris en compte et la précision de la mesure de la phase et de la fréquence.

Un tel procédé peut être appliqué à des signaux sinusoïdaux additionnés de bruit ou d'harmoniques dus à des non-linéarités.

Il peut être appliqué à des signaux de forme quelconque (carré -triangulaire - gaussien par exemple) afin d'en retrouver outre la fréquence et la phase, les caractéristiques précises de forme.

L'invention concerne également un dispositif de mise en oeuvre de ce procédé tel que défini à la revendication 4.

Ce dispositif peut être notamment un fréquencemètre qui comprend un organe de traitement numérique à l'entrée duquel est envoyé le signal à analyser après passage dans un numériseur, ce numériseur recevant également un pilote stable et à la sortie duquel on obtient le signal qualité et la mesure de fréquence.

Avantageusement cet organe de traitement numérique comprend

- un circuit mémoire commune ;
- un circuit d'élaboration du signal analytique ;
- un circuit de calcul des échantillons de la phase du signal analytique et de construction de la phase développée ;
- un circuit de qualification du signal qui permet l'estimation de la statistique des écarts avec la sinusoïde estimée et l'estimation du bruit en fonction de la forme du signal à analyser ;
- un circuit d'estimation de la fréquence, tous ces circuit étant reliés par une liaison bidirectionnelle à un bus d'interconnection ;
- un circuit d'acquisition des échantillons numérisés, situé en entrée; Ce circuit étant relié à la mémoire commune par une liaison unidirectionnelle ;
- un coupleur recevant en entrée les sorties du circuit de qualification du signal, et du circuit estimation fréquence, et dont la sortie constitue la sortie dudit organe de traitement.

Ce dispositif peut être également un phasemètre, qui comprend un deuxième numériseur qui reçoit d'une part un signal référence et d'autre part le pilote stable, l'organe de traitement comprenant :

- un deuxième circuit d'acquisition des échantillons numériques du signal référence relié comme le premier au circuit mémoire commune;
- un circuit d'estimation de phase avec le signal de référence, et d'estimation de la gigue.

Avantageusement ces dispositifs sont réalisés à partir d'une architecture matérielle comprenant plusieurs unités de calcul indépendantes entre elles et se partageant les diverses taches de calcul nécessaire à l'analyse en ayant accès à des moyens de mémoire permettant de relier lesdits moyens de calcul, ces mémoires adressables étant soit commune (bus ou multiport), soit constituées en réseau maillé, une zone exclusive étant affectée à chaque organe de calcul pour l'inscription en mémoire.

Les caractéristiques et avantages de l'invention ressortiront d'ailleurs de la description qui va suivre, à titre d'exemple non limitatif, en référence aux figures annexées sur lesquelles :

- les figures 1 à 4 sont des représentations illustrant l'opération de construction de phase développée ;
- les figures 5 et 6 sont des représentations schématiques de deux dispositifs de mise en oeuvre du procédé de l'invention.

Le procédé de l'invention comprend :

- une phase de transformation du signal à analyser en échantillons numérisés. Ces échantillons sont prélevés directement sur les signaux à traiter et stockés dans une mémoire numérique adressable. Les procédés de numérisation du signal, et de mémorisation sont des procédés connus. On peut utiliser pour ce faire des architectures basées sur des composants que l'on peut trouver dans le commerce,
- une phase de traitement des nombres ainsi obtenus, représentatifs du signal à analyser, pour les mettre sous la forme d'un signal analytique dont la partie réelle coïncide avec le signal,
- une phase d'estimation des paramètres à analyser basée sur des estimateurs et des critères de choix travaillant sur la phase du signal analytique (modulo $\pm \pi$) que l'on remplace pour simplifier les traitements par sa phase développée associée.

"modulo ± $\pi$" doit être interprété ici et dans la suite du texte, par analogie avec modulo n comme suit :

($\Phi_i$ : phase calculée ; $\Phi$ phase modulo ± $\pi$)

$$- \text{si} - \Pi < \Phi_i < + \Pi \qquad \Phi = \Phi_i$$
$$\text{si } (2k-1)\pi \leqq \Phi_i < (2k+1)\pi \qquad \Phi = \Phi_i - 2k\Pi$$
$$\text{si } -(2k+1)\pi \leqq \Phi_i < (-2k+1)\pi \quad \Phi = \Phi_i + 2k\Pi$$

avec k entier positif défini pour que

$-\pi \leqq \Phi < + \pi$

- une phase d'estimation des écarts entre le signal réel ainsi apprécié et le signal obtenu en partant des paramètres estimés permettant de délivrer sous forme numérique des données relatives à la qualité du signal analysé ainsi qu'à la sureté des valeurs estimées (facteur de forme - bruit additif - raies parasites), ces éléments d'appréciation étant bien évidemment fonction des caractéristiques de l'estimateur utilisé.

Les éléments nécessaires à la compréhension du procédé et relatifs au signal analytique et à la phase développée sont rappellés ci-après.

Le procédé de l'invention est basé sur l'utilisation de principes mathématiques connus par ailleurs et dont les résultats sont rappellés ci-dessous, et sur un procédé original de construction de la phase développée d'un signal dont les éléments sont décrits ci-après.

Le concept de signal analytique associé à un signal réel r(t) a été introduit par VILLE. Ce concept, limité au cas des signaux à "énergie finie" qui correspond aux signaux habituellement traités, permet d'associer à un signal réel r(t), une deuxième fonction q(t) du même type tel que la fonction complexe :

x(t) = r(t) + j q(t)

possède un spectre sans composante de fréquence négative.

La fonction x(t) est le "signal analytique" et la fonction q(t), le "signal en quadrature" tous deux associés à la fonction donnée r(t).

. Ainsi, dans le cas d'un signal sinusoïdal, on a :

r(t) = a cos ($2\pi\nu$ t + $\phi$) = partie réelle a exp [(j$2\pi\nu$ t + $\phi$)]
q(t) = a sin ($2\pi\nu$ t + $\phi$) = partie imaginaire a [exp (j ($2\pi\nu$ t + $\phi$)]

avec x(t) = a exp (j ($2\pi\nu$ t + $\phi$))

Ce concept, appliqué à des signaux réels à énergie finie et possédant une transformée de Fourrier, permet de disposer d'un moyen de calcul pour déduire du signal réel r(t), le signal en quadrature et ainsi, d'associer à r(t) la fonction complexe x(t) ne comportant aucune composante de fréquence négative, ce qui permet d'isoler l'amplitude et la phase du signal correspondant.

Ainsi, si :

$$r(t) = \int_{-\infty}^{+\infty} R(v) \exp (j\, 2\Pi\, vt)\, dv$$

R($\nu$) étant la transformée de Fourrier de r(t) on peut obtenir par le calcul :

$$q(t) = \int_{-\infty}^{+\infty} Q(\nu) \exp (j\ 2\Pi\ \nu t)\ d\nu$$

$Q(\nu)$ étant la transformée de Fourrier de q(t) telle que :

$Q(\nu) = -j\ R(\nu)$ si $\nu \neq o$
et $x(t) = r(t) + j\ q(t)$

De manière connue pour engendrer le signal analytique dans les équipements de démodulation et de transposition de fréquence, on utilise un mélange du signal r(t) avec respectivement une onde sinusoïdale issue d'un oscillateur local de fréquence appropriée et une onde sinusoïdale déphasée par rapport à la précédente de $\pi/2$.

Le résultat de cette opération engendre deux signaux déduit de r(t), le premier $r'(t)$ par simple transposition de r(t) dans le spectre de fréquence, le second $q'(t)$ étant en quadrature avec $r'(t)$ ; $x'(t) = r'(t) + j\ q'(t)$ représentant parfaitement toutes les caractéristiques de r(t).

On peut alors utiliser pour un signal, par exemple sinusoïdal, un procédé numérique permettant d'engendrer le signal analytique ainsi défini.

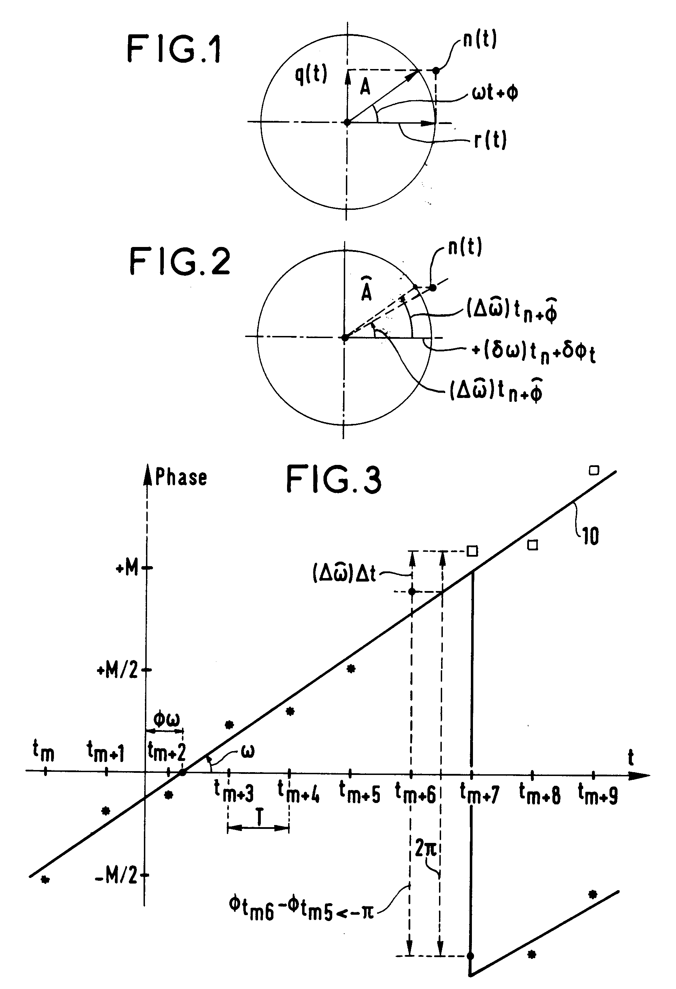

Dans le cas d'un signal sinusoïdal entaché d'un bruit additif dont le signal réel, illustré à la figure 1, est représenté par :

$$r(t) = A \cos (\omega t + \Phi) + n(t)$$

$\omega$ : pulsation
$\Phi$ : phase
$n(t)$ : bruit additif
on peut associer à ce signal le signal analytique qui s'écrit :

$x(t) = A \exp [j\ (\omega t + \Phi)] + n^*(t)$ avec $</n^*(t)/^2> = 2\sigma^2$

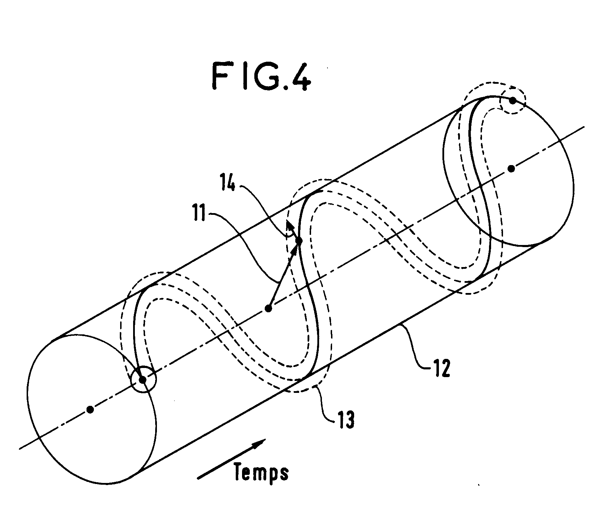

une représentation cyclindrique d'un signal analytique est illustrée à la figure 4 avec notamment : le signal sans bruit 11, l'enveloppe cylindrique du signal 12, l'enveloppe du $\sigma$ du bruit 13, et la valeur n(t) 14. La puissance du signal utile est $A^2/2$ et la variance du bruit est :

$$\sigma^2 = <n^2 (t)>$$

La transformée de Hilbert permet de lui associer un signal de la forme :

$$q(t) = A \sin (\omega t + \Phi) + n'(t)$$

avec $<n'^2(t)> = \sigma^2$
Il s'en déduit que le signal analytique correspondant est de la forme :

$$x(t) = A \exp. [j(\omega t + \Phi)] + n^*(t)$$

avec $<|n^*(t)/^2> = 2\sigma^2$
La rapport signal sur bruit $\rho$ pour les trois signaux r(t), q(t) et x(t) est le même et vaut :

$$\rho = A^2 / 2\sigma^2$$

Le signal analytique est déterminée avec une périodicité T fixée en fonction de l'incertitude $\Delta \omega$ avec laquelle on connaît la pulsation

$$\omega = \omega_0 + \Delta \omega.$$

L'échantillonnage du signal réel permet d'obtenir à chaque instant $t_n$ une valeur de phase $\Phi_n$ modulo $\pm \pi$ - (c'est-à-dire située dans l'intervalle - $\pi$ ; + $\pi$)

$$x(t) = A \exp. (j \Phi_n)$$
$$t = t_n$$

Ainsi

$$\omega_o t_n = \omega_o (t_n - T) + \omega_o$$
$$\Phi_n = (\Phi_{n-1} + \omega_o t_n) \text{ modulo } \pm\pi$$

Si on appelle :

$$\hat{\Delta \omega}: \text{ la valeur estimée de l'écart de fréquence estimé}$$

$\hat{\Phi}$ :      la valeur estimée de la phase
$\delta\omega$ :      l'écart d'estimation sur la fréquence
$\delta\Phi$ :      l'écart d'estimation sur la phase

On peut écrite $\Phi_n$ sous la forme :

$$\Phi_n = \left[ (\hat{\Delta \omega}) t_n + \hat{\Phi} + (\delta\omega) t_n + \delta\Phi \right] \text{ mod } \pm\pi$$

Un tel échantillon du signal à l'instant tn, obtenu à partir des estimations est représenté à la figure 2.

L'estimation des quantités

$$\hat{\Delta \omega}$$

et $\hat{\Phi}$ nécessite le dévelopemment de la phase de façon à éliminer le repliement modulo et se ramener ainsi à l'estimation des deux paramètres caractéristiques d'une droite.

La période T d'échantillonnage permet de raccorder sans ambiguïté les phases entre deux échantillons consécutifs. Si l'incertitute de pulsation est $\Delta \omega$, il faut que la sinusoïde à analyser tourne de moins de $\pi/2$ entre deux échantillons successifs et que la bande de bruit soit inférieure à 1/2T.

$$T < \frac{T}{.2 |\Delta \omega|}$$

Ce qui est une condition nécessaire et suffisante : le bruit ne pouvant entraîner au plus qu'un écart de phase de $\pm \pi/2$ qui additionné à la plage d'incertitude de la sinusoïde ($\pm \pi/2$) donne une plage d'incertitude inférieure à un tour ($\pm$ 1/2 tour).

De cette manière, en supposant l'unité de temps égale à la période d'échantillonnage, (t est alors un entier relatif), on peut décrire l'algorithme de calcul de la phase développée de la manière suivante :

$\Phi_t$ :      phase développée
$\phi_t$ :      phase du signal modulo $\pm\pi$
$\Delta\Phi$ :      écart de la phase développée entre deux échantillons consécutifs.

$$\Delta\Phi = \phi_{t+1} - \phi_t \qquad \text{si} \qquad -\pi < \phi_{t+1} - \phi_t < \pi$$

$$\Delta\Phi = \phi_{t+1} - \phi_t - 2\pi \quad \text{si} \qquad \phi_{t+1} - \phi_t > \pi$$

$$\Delta\Phi = \phi_{t+1} - \phi_t + 2\pi \quad \text{si} \qquad \phi_{t+1} - \phi_t < -\pi$$

$$\Phi_{t+1} = \Phi_t + \Delta\Phi$$

La figure 3 illustre l'opération de construction de phase développée qui est effectuée. La droite 10 est la droite théorique des phases et on a :

* :     valeur mesurée de la phase échantillonnée

□ :     valeur calculée de la phase développée (si différente de la valeur mesurée).

Les expressions décrites ci-dessus peuvent être résumées par :

$$\Delta\Phi = (\phi_{t+1} - \phi_t) \bmod \pm \pi$$

Suite à la construction précédente, on peut expliciter les phases développées par :

$$\tilde{\phi}_{t_n} = (\widehat{\Delta\omega}) \, t_n + \hat{\tilde{\phi}} + (\underline{\delta\omega}) \, t_n + \delta\tilde{\phi} t_n$$

qui est valable quelque soit t (suppression du modulo).

Il s'agit maintenant d'utiliser, pour l'estimation de la fréquence et de la phase, des estimateurs non biaisés c'est-à-dire tels que : $\langle\delta\omega\rangle = \langle\delta\Phi\rangle = 0$, $\delta\omega$ et $\delta\Phi$ représentant les erreurs d'estimation. Supposant que l'on dispose d'échantillons en amplitude des signaux réels r(t) et q(t) tels que décrits précédemment, on dispose pour chacun des instants d'échantillonnage $t_n$ de la phase échantillonnée :

$$\tilde{\phi}_{t_n} = \text{Arc tg} \, \frac{q(t_n)}{r(t_n)}$$

On travaille, ensuite sur les échantillons de phase ainsi obtenus. Partant de la relation:

$$\tilde{\phi}_{tn} = (\widehat{\Delta\omega}) \, t_n + \hat{\tilde{\phi}} + (\underline{\delta\omega}) \, t_n + \delta\tilde{\phi}_{tn}$$

et prenant l'origine des temps au milieu de la plage d'estimation T qui comprend l'échantillon considéré, on somme sur T les deux membres de la relation et l'on prend l'espérance mathématique du résultat. On obtient ainsi :

$$\hat{\tilde{\phi}} = \frac{1}{l} \sum_t \tilde{\phi}_{tn} \qquad \text{avec} \qquad \sum_T t_n = 0$$

l étant le nombre d'échantillons pris en compte.

Prenant la même relation dont on multiplie les deux membres par $t_n$ avant de sommer sur T et de prendre l'espérance mathématique, on obtient ainsi

$$\hat{\Delta\omega}$$

:

$$\hat{\Delta\omega} = \frac{\sum_t t_n \Phi_{tn}}{\sum_t t_n^2}$$

On peut alors calculer les variances et covariance des quantités estimées :

$$\langle(\hat{\Phi} - \Phi)^2\rangle = \frac{1}{\ell}\sigma_0^2 = \frac{1}{\ell}\frac{\sigma^2}{A^2} = \frac{1}{2}\frac{1}{\ell\rho} \quad \text{avec} \quad \rho \overset{\Delta}{=} A^2/\sigma^2$$

Les $\delta\Phi_t$ étant décorrélés avec et de variance

$$\sigma_o^2 = \frac{\sigma^2}{A^2}$$

$$\langle(\hat{\Delta\omega} - \Delta\omega)^2\rangle = \frac{\sigma_0^2}{\sum_t t_n^2} = \frac{12\sigma_0^2}{\ell^3 t^2} = \frac{12}{\ell}\frac{\sigma_0^2}{(\ell T)^2}$$

$$\langle(\hat{\Delta\omega} - \Delta\omega)(\hat{\Phi} - \Phi)\rangle = 0$$

A noter que les paramètres sont directement liés soit au facteur de forme du signal observé, soit à son rapport signal sur bruit ($\rho$).

On peut montrer que, si le bruit d'entrée engendre un bruit de phase dont la distribution est gaussienne, ces estimateurs sont optimaux au sens du maximum de vraisemblance et de l'erreur quadratique moyenne.

Comme décrit précédemment l'utilisation combinée du signal analytique et d'estimateurs basés sur la construction de la phase développée associée à la phase du signal analytique modulo $\pm \pi$ permet d'obtenir une valeur estimée de la phase et de la fréquence du signal analysé donné par:

$$\hat{\Phi} = \frac{1}{\ell}\sum_t \Phi_{tn}$$

$$\hat{\Delta f} = \frac{1}{\ell\pi}\hat{\Delta\omega} = \frac{1}{2\pi\sum_t t_n^2}\sum_t t_n \Phi_{tn}$$

$\hat{\Delta f}$ étant l'écart par rapport à la fréquence $f_o$ attendue.

Cet estimateur étant non biaisé, on obtient une erreur d'estimation dont la moyenne est nulle et dont l'écart type est donné par :

$$(\overset{\wedge}{\Delta} \omega - \Delta\omega)^2 = \frac{12}{l} \frac{\sigma_0^2}{(lT)^2}$$

avec

$$\sigma_0^2 = \frac{\sigma^2}{A^2} \qquad \sigma^2 = \langle n^2(t) \rangle \quad \text{(variance du bruit)}$$

l :      nombre d'échantillons pris en compte

T :      période d'échantillonnage

Ces résultats ne sont valables qu'à la condition que la bande de bruit du signal soit inférieure à 1/2T.

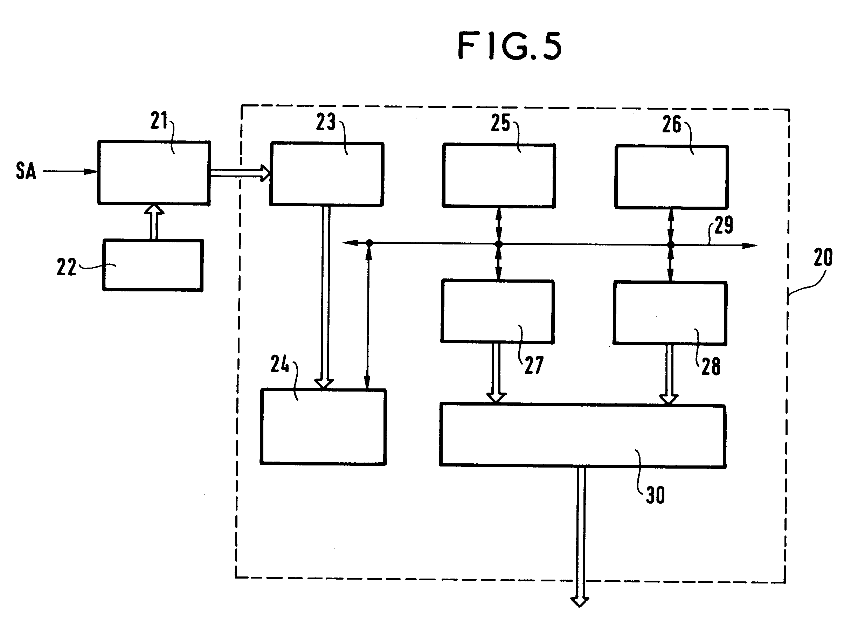

On peut, dès lors, constituer un fréquencemètre dont la structure est représentée sur la figure 5.

Un tel fréquencemètre comprend un organe de traitement numérique 20 à l'entrée duquel est envoyé le signal à analyser SA après passage dans un numériseur 21, ce numériseur recevant également un pilote stable 22, et à la sortie duquel on obtient le signal qualité et la mesure de fréquence.

L'organe de traitement numérique comprend

- un circuit 24 mémoire commune ;
- un circuit 25 d'élaboration du signal analytique ;
- un circuit 26 de calcul des échantillons de la phase du signal analytique et de construction de la phase développée ;
- un circuit 27 de qualification du signal qui permet l'estimation de la statistique des écarts avec la sinusoïde estimée et l'estimation du bruit en fonction de la forme du signal à analyser ;
- un circuit 28 d'estimation de la fréquence, tous ces circuits étant reliés par une liaison bidirectionnelle à un bus d'interconnection 29 ;
- un circuit 23 d'acquisition des échantillons numérisés, situé en entrée ; ce circuit étant relié à la mémoire commune 24 par une liaison unidirectionnelle ;
- un coupleur 30 recevant en entrée les sorties du circuit 27 de qualification signal, et du circuit 28 estimation fréquence, et dont la sortie constitue la sortie dudit organe de traitement 20.

Selon le schéma représenté, le signal à analyser est échantillonné en utilisant un pilote stable, et numérisé selon des principes connus : conversion analogique numérique dont les caractéristiques (rapidité - fréquence d'échantillonnage - linéarité...) sont un élément important pour obtenir les performances recherchées pour la précision de la mesure de fréquence et l'estimation de qualité du signal.

Le bruit propre de numérisation doit être négligeable devant les paramètres à acquérir.

Les échantillons ainsi obtenus sont acquis et mis en mémoire dans un organe de traitement numérique, mémoire adressable de dimension suffisante, afin de permettre un prélèvement autant de fois que désirable par l'un quelconque des circuits de traitement, de chacun des échantillons nécessaire aux estimations.

Chaque circuit, selon l'invention, est parfaitement indépendant des autres circuits et peut s'adresser à la mémoire pour y lire l'un quelconque des résultats obtenus par les autres circuits aussi bien que les échantillons de signaux inscrits à l'origine ainsi que ses propres résultats de calcul, ou pour y inscrire dans une zone qui est affecté à lui seul, ses propres résultats de calcul.

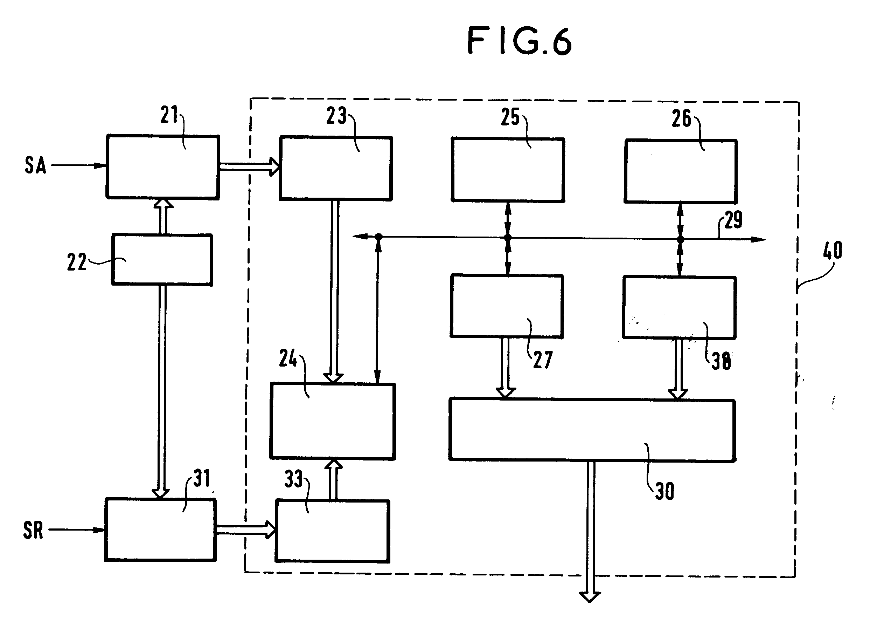

Dans le phasemètre, représenté à la figure 6, les circuits identiques à ceux utilisés dans le fréquencemètre de la figure 5 ont été représentés par le même numéro.

Ledit phasemètre comprend un deuxième numériseur 31 qui reçoit d'une part un signal référence SR et d'autre part le pilote stable 22.

L'organe de traitement numérique 40 comprend :

- un deuxième circuit d'acquisition des échantillons numériques 33 du signal référence relié comme le premier au circuit mémoire commune 24 ;
- un circuit 38 d'estimation de phase avec le signal de référence, et d'estimation de la gigue.

Dans chacun de ces deux dispositifs (fréquencemètre, phasemètre) il y a donc successivement :

. numérisation du signal réel à analyser.

Cette numérisation utilise des procédés connus élaborés dans des composants existants sur le marché. Le choix des caractéristiques du numériseur utilisé doit tenir compte du signal à analyser afin de ne pas entacher d'erreurs le résultat des estimations.

Les principales caractéristiques sont les suivantes :

a) fréquence d'échantillonnage et filtre "antialiasing" ;

La fréquence d'échantillonnage choisie doit avoir une valeur $F_e$ compatible avec la bande de fréquence $\Delta F_n$ des signaux de bruit associés au signal à analyser :

$$F_e > 2\Delta F_n$$

Le filtre "antialiasing" précédant le numériseur doit être défini en vue de limiter la bande des signaux à numériser à la demi-fréquence d'échantillonnage, la caractéristique dans la bande dépendant de la fonction de transfert de l'échantillonneur.

b) la linéarité de l'échantillonneur ;

c) les caractéristiques de la quantification.

Le nombre d'échelons de quantification ainsi que la précision et la stabilité des seuils correspondant doivent entraîner un effet négligeable sur les résultats.

. transformation des échantillons du signal réel issu de la numérisation en un signal analytique échantillonné comprenant en particulier le calcul des échantillons du signal en quadrature à partir d'un groupe d'échantillons du signal réel.

L'une des méthodes possibles qui peut être adoptée dans le cas ou l'on dispose d'une fréquence d'échantillonnage élevée relativement à la bande de signal à numériser peut être réalisé de la manière suivante :

- Définition d'une fréquence d'échantillonnage (N fois supérieur) multiple entière d'une fréquence quatre fois supérieure à la bande de fréquence à analyser.
- Prise en compte d'échantillons consécutifs à raison d'une paire tous les N échantillons. Chacun des échantillons pris en compte est représentatif, le premier du signal réel, le deuxième du signal en quadrature (décalage de $\pi/2$ en considérant la période initiale d'échantillonnage).

Cette méthode réclame une fréquence d'échantillonage élevée par rapport à la bande à analyser.

Pour le cas ou cette condition n'est pas remplie, il y a lieu de procéder par interpolation des signaux réels d'origine en vue d'obtenir les deux échantillons en quadrature avec le signal équivalent réel.

Le signal analytique peut aussi être mémorisé sous forme d'échantillons complexes $[n^*(t) + j\ q^*(t)]$ apparaissant à un rythme

$$F_{SA} > \frac{\Delta \overline{F}_n}{2}$$

$\Delta F_n$ représentant la bande de fréquence du signal traité.

Partant des échantillons complexes du signal analytique, on élabore les échantillons de phase associés et la phase developpée comme indiqué précédemment.

On en déduit, en utilisant les estimateurs décrit précédemment

- la valeur de la phase et de la fréquence estimée d'une sinusoïde.
- la variance et la covariance des quantités estimées avec comme référence le signal d'entrée.

On obtient ainsi, avec comme paramètre le nombre d'échantillons pris en compte :

- la valeur de la fréquence,
- la valeur de la phase,
- le bruit d'estimation de la mesure.

Ce dernier élément permet de qualifier la mesure en apportant toute la précision désirable. En effet ce bruit d'estimation globalise tous les bruits qu'ils soient issus

- d'un bruit additionné au signal ;
- d'une non linéarité de la chaîne à mesurer, les non linéarité de l'appareillage de mesure étant éliminées ou tout au moins réduites à des valeurs négligeable devant la précision recherchée ;
- d'un bruit de phase issu d'un oscillateur local dans la chaîne à mesurer ;
- du facteur de forme des signaux à analyser (on peut avoir à mesurer des signaux rectangulaires, triangulaires, gaussiens...) le bruit qui résulte est dû alors aux harmoniques ;
- des erreurs d'estimations de la chaîne de mesure liées aux estimateurs.

S'agissant d'un signal sinusoïdal, on procède comme suit : Partant des estimateurs de fréquence et de phase, on modélise le signal sinusoïdal théorique déduit de l'estimation.

Si l'on regarde la variance de la phase, elle est proportionnelle au bruit et inversement proportionnelle au nombre d'échantillons. On peut donc qualifier la mesure de phase à partir du nombre d'échantillons pris en compte et de la variance de la phase calculée et en déduire le rapport (signal/bruit) du signal en test

$$\frac{A^2}{\sigma^2} = \frac{1}{1} \frac{1}{\langle(\hat{\Phi} - \Phi)^2\rangle}$$

Evaluant la variance de l'estimation de fréquence, il est possible de définir le nombre d'échantillons à prendre en compte, le bruit $\sigma_o^2$ étant connu (voir ci-dessus) de maitriser sans ambiguïté la précision de l'estimation.

S'agissant d'un signal dont on connaît la forme, on modélise le signal correspondant avec l'amplitude, la phase et la fréquence estimée et l'on peut alors procéder comme pour un signal sinusoïdal.

Le procédé de l'invention permet donc :
- ne connaissant pas le bruit qui entache le signal à mesurer, d'ajuster la durée de signal prise en compte afin de rendre la variance de la phase faible et d'évaluer :
  - le

$$\frac{\dot{A}^2}{\dot{\varsigma}^2}$$

  du signal à mesurer,
  - la précision correspondante de la mesure de fréquence,
  - la valeur de la phase,
  - la valeur de la fréquence ;
  - ne connaissant pas la forme d'un signal, de la modéliser pour obtenir le taux d'harmonique du signal à mesurer et ainsi d'en déduire les autres éléments ;
- connaissant le type de bruit additionné au signal et son enveloppe, de modéliser ce bruit afin d'en tenir compte pour évaluer les autres pertubations :
  - harmonique
  - bruit de phase...

Par ailleurs toute architecture matérielle permettant de matérialiser les conditions citées ci-après est applicable au procédé :
. Partage des taches entre différents organes de calcul travaillant indépendamment les uns des autres ;
. Accès indépendant en lecture de l'un quelconque des organes de calcul définis ci-dessus à tous les résultats des taches effectuées par les autres organes. Ce type d'accès peut être organisé, par exemple, autour de mémoires adressables accessibles par bus commun ou "multiport", ou bien à partir de mémoire constituées en un réseau maillé interconnectant les différents organes de calcul ;
. Inscription exclusive dans chacune des zones délimitées de la (ou des) mémoire par un organe de calcul préalablement désigné.

Ainsi les différents circuits des dispositifs (fréquencemètre, phasemètre) mettant en oeuvre le procédé selon l'invention peuvent aussi être remplacées par différentes fonctions d'estimation implantées sur des organes de calcul réalisé par logiciel.

## Revendications

1. Procédé d'évaluation numérique de la fréquence et de la phase de signaux sous forme d'échantillons numérisés comprenant une phase de traitement des nombres correspondant aux échantillons du signal à analyser pour les mettre sous forme d'un signal analytique dont la partie réelle coïncide avec ledit signal à analyser ; caractérisé en ce que ledit procédé comprend en parallèle :
   - Une phase d'estimation des paramètres à analyser effectuée de manière globale à partir d'estimateurs optimaux au sens du maximum de vraisemblance et de l'erreur quadratique moyenne et de critères de choix travaillant de manière non récursive sur la phase du signal sans qu'aucun opérateur de type transformée de Fourrier ni test d'hypothèses ne soit utilisé séparé-

EP 0 295 160 B1

ment ou simultanément ;
- Une phase d'estimation des écarts entre le signal réel ainsi apprécié et le signal obtenu en partant des paramètres estimés permettant de délivrer sous forme numérique des données relatives à la qualité du signal analysé ainsi qu'à la sûreté de valeurs estimées.

2. Procédé selon la revendication 1, caractérisé en ce que dans la phase d'estimation des paramètres à analyser la phase du signal analytique est remplacée par sa phase développée associée.

3. Procédé selon l'une quelconque des revendications 1 ou 2, caractérisé en ce que, les échantillons de départ sont stockés en mémoire d'où ils sont extraits autant de fois que nécessaire pour chaque nouveau calcul aboutissant, avec une précision donnée au rapport signal/bruit du signal analysé, à la durée du signal pris en compte et à la précision de la mesure de la phase et de la fréquence, tout ceci en partant d'un paramètre de qualité donné.

4. Dispositif de mise en oeuvre du procédé selon l'une quelconque des revendications précédentes, caractérisé en ce qu'il comprend :
- un organe de traitement numérique (20) à l'entrée duquel est envoyé le signal à analyser (SA) après passage dans un numériseur (21), ce numériseur recevant également un pilote stable et numérisé (22), et la sortie duquel on obtient le signal qualité et la mesure de fréquence.

5. Dispositif selon la revendication 4, caractérisé en ce que l'organe de traitement numérique comprend :
- un circuit (24) mémoire commune ;
- un circuit (25) d'élaboration du signal analytique ;
- un circuit (26) de calcul des échantillons de la phase du signal analytique et de construction de la phase développée ;
- un circuit (27) de qualification du signal qui permet l'estimation de la statistique des écarts avec la sinusoïde estimée et l'estimation du bruit en fonction de la forme du signal à analyser ;
- un circuit (28) d'estimation de la fréquence, tous ces circuits étant reliés par une liaison bidirectionnelle à un bus d'interconnection (29) ;
- un circuit (23) d'acquisition des échantillons numérisés, situé en entrée ; ce circuit étant relié à la mémoire commune (24) par une liaison unidirectionnelle ;
- un coupleur (30) recevant en entrée les sorties du circuit (27) de qualification signal, et du circuit (28) estimation fréquence, et dont la sortie constitue la sortie dudit organe de traitement (20).

6. Dispositif selon l'une quelconque des revendications 4 ou 5, caractérisé en ce qu'il comprend :
- un deuxième numériseur (31) qui reçoit d'une part un signal référence (SR) et d'autre part le pilote stable (22).

7. Dispositif selon la revendication 6, caractérisé en ce que l'organe de traitement numérique (40) comprend :
- un deuxième circuit d'acquisition des échantillons numériques (33) du signal référence relié comme le premier au circuit mémorisé comme (24) ;
- un circuit (38) d'estimation de phase avec le signal de référence, et d'estimation de la gigue.

8. Dispositif selon l'une quelconque des revendications 4 à 7, caractérisé en ce qu'il est réalisé à partir d'une architecture matérielle comprenant plusieurs unités de calcul indépendantes entre elles et se partageant les diverses taches de calcul nécessaire à l'analyse en ayant accès à des moyens de mémoire permettant de relier lesdits moyens de calcul, ces mémoires adressables étant soit communes, tel que bus ou multiport, soit constituées en réseau maillé, une zone exclusive étant affectée à chaque organe de calcul pour l'inscription en mémoire.

**Claims**

1. A method of digitally evaluating the frequency and the phase of signals in the form of digitized samples, the method comprising a stage during which numbers corresponding to the samples of the signal to be analyzed are processed in order to convert them into the form of an analytic signal whose real portion coincides with said signal to be analyzed; the method being characterized in that it includes in parallel:

13

EP 0 295 160 B1

a stage of estimating the parameters to be analyzed which is performed in an overall manner on the basis of estimators that are optimum in the sense of greatest likelihood and of mean square error and of selection criteria by working non-recursively on the phase of the signal without using any operator of the Fourier transform type or any hypothesis test either separately or simultaneously; and

a stage of estimating the differences between the real signal as taken in this way and the signal obtained from the estimated parameters, thereby making it possible to deliver data in digital form relating to the quality of the analyzed signal and to the reliability of the estimated values.

2. A method according to claim 1, characterized in that during the stage of estimating the parameters to be analyzed, the phase of the analytic signal is replaced by its associated developed phase.

3. A method according to claim 1 or 2, characterized in that the initial samples are stored in a memory from which they are extracted as often as may be required by each new calculation giving rise, to within given accuracy, to the signal/noise ratio of the analyzed signal, to the duration of the signal to be taken into account, and to the accuracy of the phase measurement and of the frequency measurement, with the above being based on a given quality parameter.

4. A device for implementing the method according to any preceding claim, characterized in that it comprises:

a digital processor member (20) having an input to which the signal to be analyzed (SA) is applied after passing through a digitizer (21), said digitizer also receiving a stable digital clock signal (22), with the output from the digital processor member providing a quality signal and a frequency measurement signal.

5. A device according to claim 4, characterized in that the digital processor member comprises:

a common memory circuit (24);

a circuit (25) for generating the analytic signal;

a circuit (26) for calculating samples of the phase of the analytic signal and for constructing the developed phase;

a circuit (27) for determining the quality of the signal and enabling an estimate to be made of the statistics of the differences from the estimated sinewave and the estimated noise as a function of the form of the signal to be analyzed;

a circuit (28) for estimating frequency;

with all of the above circuits being connected via respective both-way links to an interconnection bus (29);

an input circuit (23) for acquiring digitized samples, said circuit being connected to the common memory (24) via a one-way link; and

a coupler (30) having its inputs connected to the outputs from the circuit (27) for determining the quality of the signal and from the circuit (28) for estimating its frequency, and whose output constitutes the output from said processor member (20).

6. A device according to claim 4 or 5, characterized in that it includes a second digitizer (31) which receives both a phase reference signal (SR) and the stable clock signal (22).

7. A device according to claim 6, characterized in that the digital processor member (40) includes:

a second circuit for acquiring digital samples (33) of the phase reference signal and connected like the first sample acquisition circuit to the common memory circuit (24); and

a circuit (38) for estimating the phase relative to the reference signal, and for estimating the jitter.

8. A device according to any one of claims 4 to 7, characterized in that it is implemented using a hardware structure comprising a plurality of mutually independent calculation members which share the various calculation tasks required for the analysis and which have access to the memory means which serve to interconnect said calculation members, said addressable memories being either common such as a bus or a multiport, or else constituted as a lattice network, with an exclusive zone being attributed to each calculation member for writing in memory.

**Patentansprüche**

14

1. Verfahren zur digitalen Auswertung von Frequenz und Phase eines Signals in Form von digitalisierten Tastproben, mit einem Schritt der Bearbeitung der den Tastproben des zu analysierenden Signals entsprechenden Zahlen, um sie in Form eines analytischen Signals zu bringen, dessen reeller Teil mit dem zu analysierenden Signal zusammenfällt, dadurch gekennzeichnet, daß das Verfahren die folgenden parallel ablaufenden Schritte enthält:

- einen Schritt der Abschätzung der zu analysierenden Parameter, der global ausgehend von optimalen Schätzvorrichtungen im Sinne des Maximums der Wahrscheinlichkeit und des mittleren quadratischen Fehlers sowie ausgehend von gewählten Kriterien durchgeführt wird, wobei auf nicht rekursive Weise die Signalphase bearbeitet wird ohne getrennte oder gleichzeitige Verwendung eines Operators vom Typ einer Fouriertransformierten oder von Überprüfungen der Hypothesen;
- einen Schritt der Abschätzung der Abweichungen zwischen dem echten so bewerteten Signal und dem erhaltenen Signal ausgehend von den geschätzten Parametern, wobei dieser Schritt in digitaler Form Daten zu liefern vermag betreffend die Qualität des so analysierten Signals und die Sicherheit von geschätzten Werten.

2. Verfahren nach Anspruch 1, dadurch gekennzeichnet, daß in dem Schritt der Abschätzung der zu analysierenden Parameter die Phase des analytischen Signals durch die zugeordnete entwickelte Phase ersetzt wird.

3. Verfahren nach einem beliebigen der Ansprüche 1 oder 2, dadurch gekennzeichnet, daß die ursprünglichen Tastproben in einem Speicher enthalten sind, aus dem sie so oft wie nötig für jede neue Rechnung entnommen werden, was mit der durch das Signal/Rauschverhältnis des analysierten Signals gegebenen Genauigkeit zur Dauer des berücksichtigten Signals und der Genauigkeit der Phasen- und der Frequenzmessung führt, und zwar ausgehend von einem gegebenen Qualitätsparameter.

4. Vorrichtung zur Durchführung des Verfahrens nach einem beliebigen der vorhergehenden Ansprüche, dadurch gekennzeichnet, daß sie ein digitales Bearbeitungsorgan (20) aufweist, an dessen Eingang das zu analysierende Signal (SA) nach Umwandlung in einem Analog-Digital-Wandler (21) angelegt wird, wobei dieser Wandler außerdem ein digitales und stabiles Pilotsignal (22) zugeführt erhält, während am Ausgang des Behandlungsorgans das Qualitätssignal und die Frequenzmessung zur Verfügung stehen.

5. Vorrichtung nach Anspruch 4, dadurch gekennzeichnet, daß das digitale Bearbeitungsorgan aufweist:
- einen gemeinsamen Speicherkreis (24),
- einen Kreis (25) zur Erarbeitung des analytischen Signals,
- einen Kreis (26) zur Berechnung der Phasentastproben des analytischen Signals und zur Konstruktion der entwickelten Phase,
- einen Signalqualifizierkreis (27), der die Abschätzung der Statistik der Abweichungen von der geschätzten Sinusform und die Abschätzung des Rauschens abhängig von der Form des zu analysierenden Signals erlaubt,
- einen Frequenzschätzkreis (28), wobei all diese Kreise über eine bidirektionale Verbindung an einen Verbindungsbus (29) angeschlossen sind,
- einen Kreis (23) zur Erfassung der digitialisierten Tastproben, der sich am Eingang befindet und an den gemeinsamen Speicher (24) über eine unidirektionale Verbindung angeschlossen ist,
- einen Koppler (30), der am Eingang die Ausgangssignale des Signalqualifizierkreises (27) und des Frequenzschätzkreises (28) zugeführt erhält und dessen Ausgang den Ausgang des Bearbeitungsorgans (20) bildet.

6. Vorrichtung nach einem beliebigen der Ansprüche 4 oder 5, dadurch gekennzeichnet, daß sie aufweist:
- einen zweiten Analog-Digital-Wandler (31), der einerseits ein Bezugssignal (SR) und andererseits das stabile Pilotsignal (22) zugeführt erhält.

7. Vorrichtung nach Anspruch 6, dadurch gekennzeichnet, daß das digitale Bearbeitungsorgan (40) aufweist:
- einen zweiten Kreis zur Erfassung der digitalen Tastproben (33) des Bezugssignals, der wie der erste mit dem gemeinsamen Speicherkreis verbunden ist,
- einen Phasenschätzkreis (38) zur Abschätzung der Phase bezüglich des Bezugssignals und zur Abschätzung der Schwebung.

15

**8.** Vorrichtung nach einem beliebigen der Ansprüche 4 bis 7, dadurch gekennzeichnet, daß sie von einem Aufbau ausgeht, der mehrere voneinander unabhängige Recheneinheiten enthält, die sich die verschiedenen für die Analyse notwendigen Aufgaben aufteilen, indem sie auf Speichermittel Zugriff haben, die die Rechenmittel miteinander verbinden können, wobei diese adressierbaren Speicher entweder gemeinsame Speicher sind, wie z.B. ein Bus oder ein Multiport, oder aus einer vernetzten Struktur bestehen, wobei eine Zone jedem Rechenorgan zum Einspeichern exklusiv zugeordnet ist.

FIG.1

FIG.2

FIG.3

# FIG.4

14

11

12

13

Temps

# FIG.5

EP 0 295 160 B1

# FIG.6

EP 0 295 160 B1